# EUROPEAN PATENT APPLICATION

(11) **EP 1 970 758 A2**
(43) Date of publication of application: **17.09.2008**
(21) Application number: 08102016.6
(22) Date of filing: 26.02.2008
(51) Int. Cl.: G03F 7/00, G03F 7/09

(54) **Method for producing structure**

(30) Priority: 16.03.2007 JP 2007067865
(71) Applicant: FUJITSU LIMITED, Kawasaki-shi, Kanagawa 211-8588 (JP)
(72) Inventor: Matsushita, Naohisa Fujitsu Limited, Kawasaki-shi, Kanagawa 211-8588 (JP); Iida,, Susumu Fujitsu Limited, Kawasaki-shi, Kanagawa 211-8588 (JP)
(74) Representative: Stebbing, Timothy Charles

(57) **Abstract**

According to the present invention, a method is provided for manufacturing a structure composed of a photoreactive resin comprising the steps of: forming the photoreactive resin on a sheet member soluble in water (1200); exposing the photoreactive resin selectively to a radiation activating the photoreactivity to produce the structure (1300, 1400); and dissolving the sheet member in water after the exposing step (1500).

## Description

The present invention relates to a method for producing a structure comprising a photoreactive resin or a photocurable resin. The photoreactive resin (photosensitive resin) is generally referred to as a resist and subjected to development. The photocurable resin is used for stereolithography. A common point among these resins is that a photoreaction is effected using light. Unless otherwise specified, these resins are referred to as "photoreactive resins" in this specification.

According to an aspect of the present invention, there is provided a method for manufacturing (producing) a structure comprising a photoreactive resin having photoreactivity, comprising the steps of: forming the photoreactive resin on a sheet member soluble in water; exposing the photoreactive resin selectively to a radiation activating the photoreactivity to produce the structure; and dissolving the sheet member in water after the exposing step.

Embodiments of the present invention will now be described with reference to the accompanying drawings, of which:
FIG. 1 shows the steps in a method for producing a structure according to an embodiment of the present invention;
FIGs. 2A to 2E are schematic cross-sectional views in the steps in the production method shown in FIG. 1;
FIG. 3 shows the steps in a method for producing a structure according to another embodiment of the present invention;
FIG. 4 illustrates an example of Step 1600 shown in FIG. 3;
FIGs. 5A to 5D illustrate the steps in the production method shown in FIG. 3;
FIG. 6 illustrates another example of Step 1600 shown in FIG. 3;
FIGs. 7A to 7C illustrate the steps in the production method shown in FIG. 6;
FIG. 8 shows the steps in a method for producing a structure according to another embodiment of the present invention;
FIGs. 9A to 9C are schematic cross-sectional view illustrating Step 1700 shown in FIG. 8;
FIG. 10 shows the steps in a method for producing a structure according to another embodiment of the present invention;
FIG. 11 illustrates an example of details of Step 1800 shown in FIG. 10;
FIG. 12 illustrates an example of details of Step 1900 shown in FIG. 10;
FIGs. 13A to 13F are schematic cross-sectional views of examples corresponding to the steps shown in FIG. 10;
FIGs. 14A to 14G are schematic cross-sectional views of other examples corresponding to the steps shown in FIG. 10;
FIG. 15 illustrates another example of the details of Step 1800 shown in FIG. 11;
FIG. 16 illustrates another example of the details of Step 1900 shown in FIG. 12;
FIGs. 17A to 17F are schematic cross-sectional views of examples corresponding to the steps shown in FIGs. 14A to 15;
FIG. 18 shows the steps in a method for producing a structure according to another embodiment of the present invention;
FIGs. 19A to 19E are schematic cross-sectional views of the steps in the production method shown in FIG. 18;
FIG. 20 shows the steps in a method for producing a structure according to another embodiment of the present invention; and
FIGs. 21A to 21C are schematic cross-sectional views illustrating the production method shown in FIG. 20.

The demand for microstructures, e.g. biodevices and optical devices, composed of photoreactive resins has been increasing. To produce microstructures, employment of lithography (exposure) in which a mask pattern is transferred to a resin and nanoimprinting in which a mold pattern is transferred have been devised. However, lithography is a technique for transferring a pattern to a substrate under a photoreactive resin through steps of development, etching, and detachment of the photoreactive resin after exposure. Nanoimprinting is a technique for transferring a pattern to a substrate under the photoreactive resin through steps of etching and detachment of the photoreactive resin after imprinting. Thus, these techniques cannot be employed for production of structures composed of photoreactive resins.

Furthermore, a photoreactive resin before exposure is in a liquid state usually. Thus, to support the photoreactive resin, the photoreactive resin needs to be applied to a substrate. Hence, the photoreactive resin needs to be detached from the substrate after the completion of pattern transfer. However, it is difficult to detach the photoreactive resin. The structure may be damaged.

In stereolithography, a liquid ultraviolet-curable resin is cured and laminated with an ultraviolet laser of a stereolithography system to form a three-dimensional structure in a short time. However, similarly, it is difficult to detach the three-dimensional structure from a table used for forming the three-dimensional structure.

A technique in which a photoreactive resin is detached from a substrate with a special remover after exposure has been proposed. However, the technique using the special remover is not practical because of the need for a storage environment at about -20°C and pretreatment of exposure (increase in temperature to room temperature, defoaming, and the like). It is difficult to simply produce a structure composed of a photoreactive resin, e.g. a microstructure device having a through hole pattern.

Accordingly, it is desirable to provide a method for simply producing a structure composed of a photoreactive resin without damaging the structure.

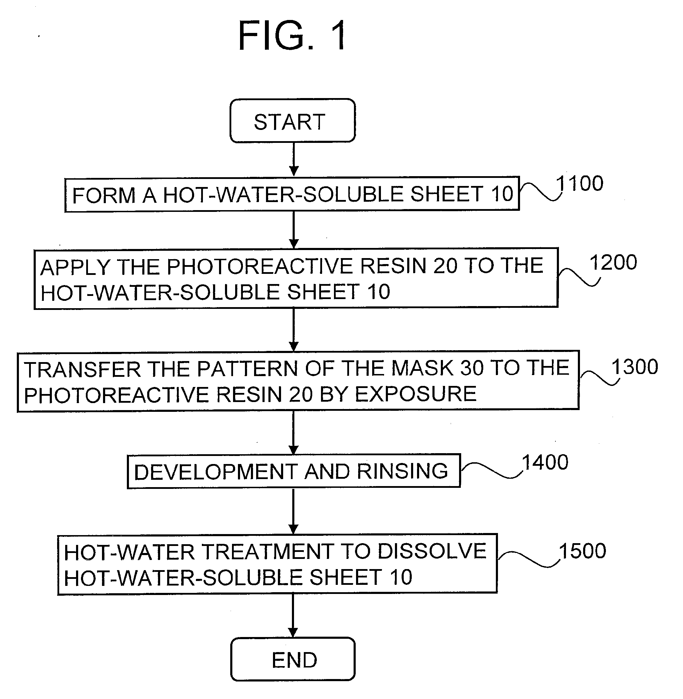

A method for producing a structure according to an embodiment of the present invention will be described below with reference to the attached drawings. FIG. 1 shows the steps in the production method.

A hot-water-soluble sheet 10 is formed (Step 1100). The hot-water-soluble sheet 10 is a sheet member soluble in hot water and is composed of one of agar and a polyvinyl alcohol (PVA) resin. These materials are also environmentally friendly. Agar is soluble in hot water having a temperature of about 50°C or higher. The PVA resin is soluble in hot water having a temperature of about 80°C or higher. The size and shape of the hot-water-soluble sheet 10 are not particularly limited.

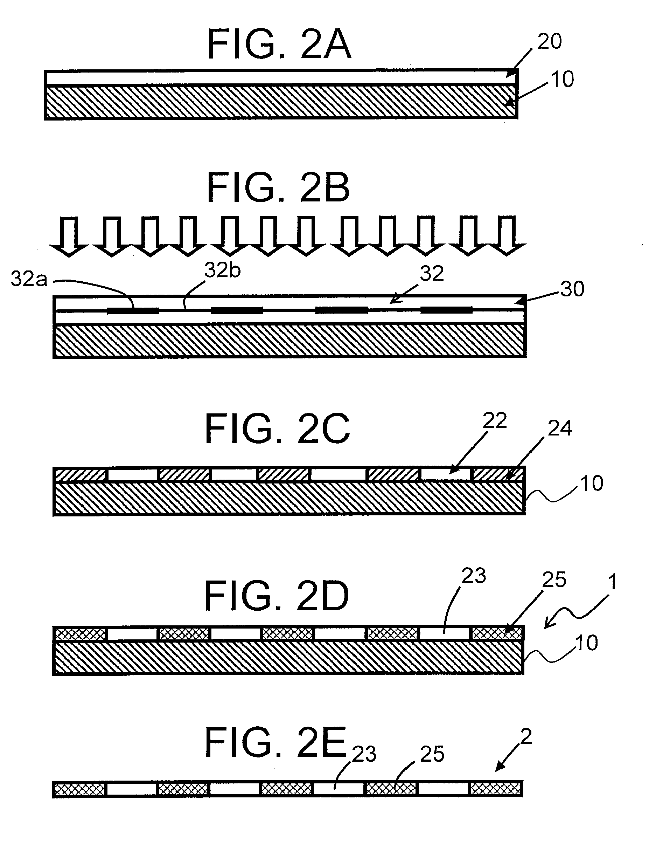

A photoreactive resin 20 is applied to the hot-water-soluble sheet 10 (Step 1200). Examples of the photoreactive resin that can be used include, but are not limited to, polyvinyl cinnamate, cyclized polyisoprene-bisazide, novolac resins, fluorocarbon resins, and alicyclic resins. A coater may be used for application. FIG. 2A is a schematic cross-sectional view in this state.

A pattern 32 of the mask 30 including a light-shading portion 32a and a light-transmitting portion 32b is subjected to exposure, thereby transferring the pattern to the photoreactive resin 20 (Step 1300). A mercury lamp or an excimer laser system may be used as a light source for exposure. The type of exposure light used is not particularly limited. The transferred pattern may have the same size as or a smaller than its original size. An illumination optical system that illuminates the mask 30 by means of light from the light source may be disposed between the light source and the mask 30. A projection optical system that projects light from the mask 30 on the photoreactive resin 20 may be disposed between the mask 30 and the photoreactive resin 20. These optical systems include lenses, mirrors, aperture diaphragms, and the like. The mask 30 may be of a transmissive or reflective type. FIG. 2B is a schematic cross-sectional view showing a state during exposure. In FIG. 2B, the mask 30 is in contact with the photoreactive resin 20, and the transferred pattern has the same size as its original size. The present invention includes the cases in which a projection optical system is disposed and the transferred pattern has the same size as or a smaller size than its original size. FIG. 2C is a schematic cross-sectional view showing a state of the photoreactive resin 20 after completion of exposure. The photoreactive resin 20 includes an unexposed portion 22 formed by shielding the portion from light with the pattern and an exposed portion 24 formed by exposing the portion to light to effect curing. After completion of exposure, the mask 30 is detached from the photoreactive resin 20.

Development and rinsing (Step 1400) are performed. The hot-water-soluble sheet 10 is insoluble in a developing agent or a detergent. As shown in FIG. 2D, the unexposed portion 22 is removed to form a hole. The exposed portion 24 is left as a cured resin 25. If the photoreactive resin 20 is a positive resist, a reverse pattern of the negative resist shown in FIG. 2D is obtained. FIGs. 2A to 2E are schematic cross-sectional views of the structure 1 including the photoreactive resin 20 and the hot-water-soluble sheet 10 after completion of development.

Hot-water treatment is performed (Step 1500). The temperature of water used is about 50°C or higher for agar and about 80°C or higher for a PVA resin. As shown in FIG. 2E, the hot-water-soluble sheet 10 is dissolved in hot water to leave a microstructure 2. The microstructure 2 includes a pattern of through holes 23.

According to the production method, the sheet member is dissolved in hot water to detach the structure from the sheet member. There is no possibility of damage to the structure because the sheet member is only soaked in hot water. Thus, the (micro)structure formed by transferring the pattern by exposure can be obtained simply and stably. Hot water is inexpensive and also environmentally friendly.

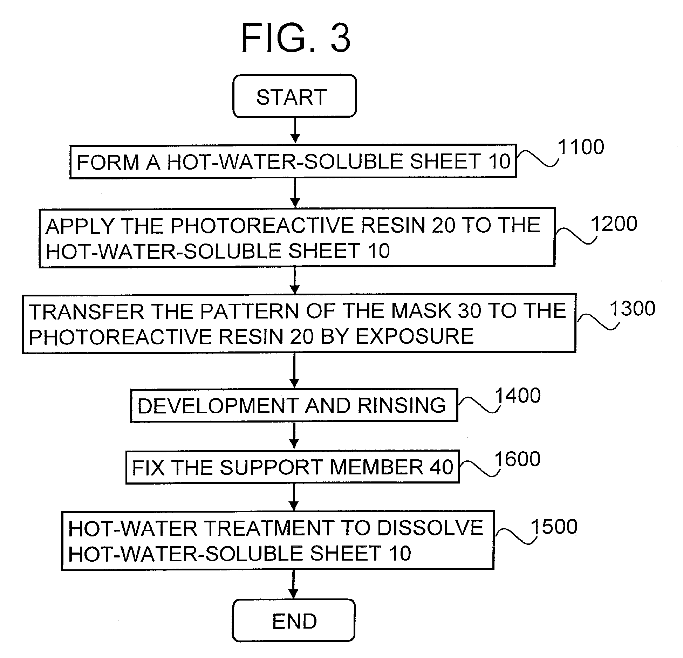

The structure 2 shown in FIG. 2E may be used alone. The structure 2 may be used together with a support member 40. The support member 40 may be attached to the structure 2 in order to merely support or reinforce the structure 2. The support member 40 may have an optical effect. An embodiment will be described below with reference to FIGs. 3 to 5D. FIG. 3 shows a modification of the steps in the production method shown in FIG. 1. FIG. 3 differs from FIG. 1 in that Step 1600 is provided between Steps 1400 and 1500. Referring to FIG. 3, the support member 40 is fixed to the developed photoreactive resin 20 (Step 1600) subsequent to Step 1400.

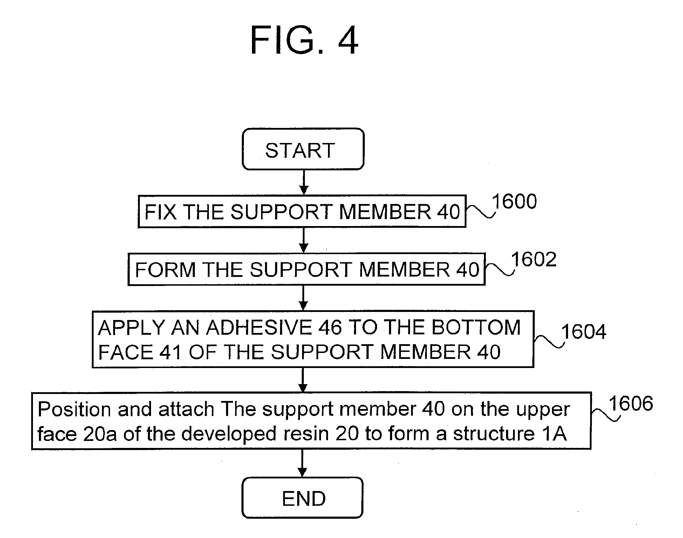

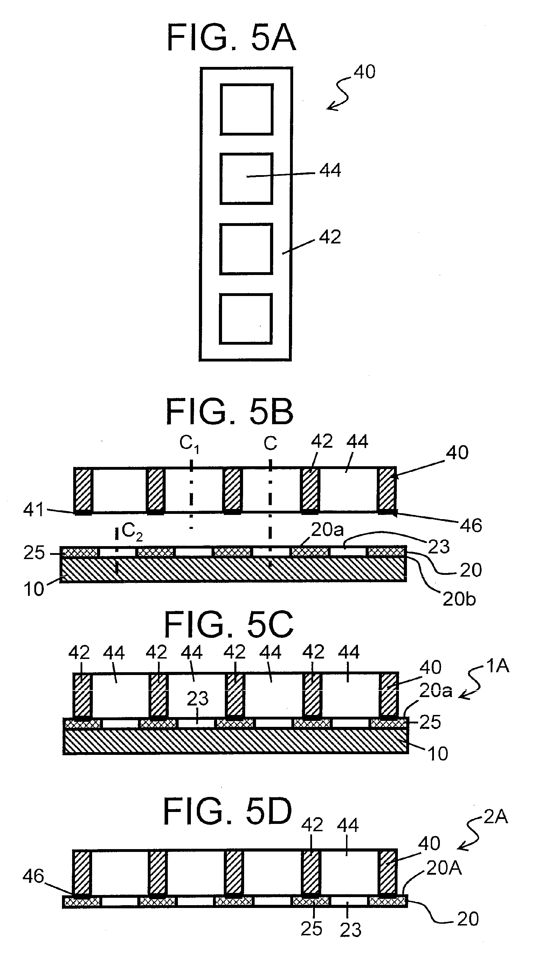

Step 1600 will be described below in detail with reference to FIG. 4. FIG. 4 illustrates Step 1600 shown in FIG. 3. The support member 40 is formed (Substep 1602). As shown in FIG. 5A, the support member 40 according to this embodiment has hollow rectangular columns when viewed in plan. However, the shape and size thereof are not particularly limited. The support member 40 includes posts 42 and openings 44. The posts 42 support the photoreactive resin 20. The thickness and shape of each post 42 are not limited. The openings 44 communicate with through holes 23. The length and size of each opening 44 are not limited.

An adhesive 46 is applied to the bottom face 41 of the support member 40 (Substep 1604). The material constituting the adhesive 46 is not limited. The adhesive 46 is required not to be detached during the hot-water treatment. The support member 40 is positioned and attached on the upper face 20a of the developed resin 20 to form a structure 1A (Substep 1606). An upper face 20a is disposed opposite a lower face 20b to which the hot-water-soluble sheet 10 is attached. In the structure 1A, the hot-water-soluble sheet 10 is fixed to the lower face 20b of the photoreactive resin 20, and the support member 40 is fixed to the upper face 20a of the photoreactive resins 20. FIG. 5B is a schematic cross-sectional view showing a state after positioning. The center line C₁ of each opening 44 and the center line C₂ of a corresponding one of the through holes 23 are aligned with a center line C. Each post 42 is positioned in the center of a corresponding one of the cured photoreactive resin 25. FIG. 5C is a schematic cross-sectional view of the hot-water-soluble sheet 10 and the photoreactive resin 20 having the upper face 20a to which the support member 40 is bonded.

Step 1500 is performed to obtain a structure 2A as shown in FIG. 5D. In the structure 2A, the support member 40 is fixed to the upper face 20A of the photoreactive resin 20 with the adhesive 46. According to this embodiment, the resin structure supported by or reinforced with the support member can be obtained.

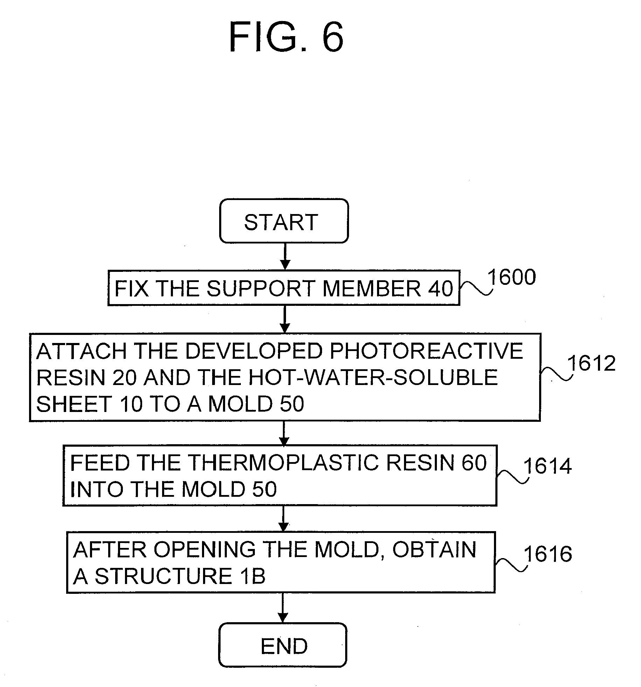

A modification of Step 1600 will be described below with reference to FIG. 6. FIG. 6 illustrates Step 1600. In FIG. 6, formation and mounting of the support member 40 are performed in a single step.

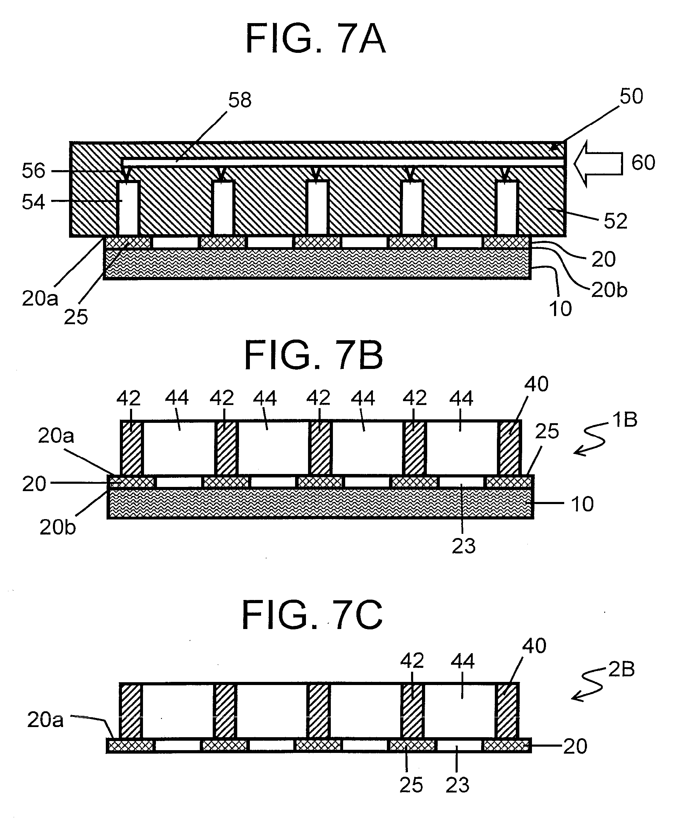

The developed photoreactive resin 20 and the hot-water-soluble sheet 10 are attached to a mold 50 (Substep 1612). The mold 50 is attached to the upper face 20a of the photoreactive resin 20. FIG. 7A shows a state of a cavity in the mold 50 clamped. The mold 50 has channels 54, 56, and 58. The channel 54 defines the shape of the support member 40. The channels 56 taper and are provided in response to the channel 54. A resin 60 is separated between the channels 54 and 56. The mold 50 may be separated between the channels 54 and 56 into an upper mold section and a lower mold section. Each of the channels 56 is connected to the channel 58. The channel 58 supplies the channels 56 with the thermoplastic resin 60. Nonlimiting examples of the thermoplastic resin include polycarbonate and polyether imide. A metal element and an organic material may be incorporated.

After clamping, the thermoplastic resin 60 is fed into the mold 50 (Step 1614). In this embodiment, the temperature-controlled thermoplastic resin 60 is fed from a supply source (not shown) into the mold 50 through the channel 58 by injection molding. An injection molding apparatus as is well known to those skilled in the art may be used. The support member 40 can be produced by injection molding with high accuracy. The thermoplastic resin 60 is integrated with the photoreactive resin 20 when the resin 60 is fed. Thus, the adhesive 46 shown in FIG. 5B does not need.

After opening the mold, a structure 1B as shown in FIG. 7B is obtained (Substep 1616). The structure 1B includes the hot-water-soluble sheet 10 attached to the lower face 20b of the photoreactive resin 20 and the support member 40 attached to the upper face 20a of the photoreactive resin 20. Unlike the structure 1A, the structure 1B does not include the adhesive 46 between the support member 40 and the upper face 20a of the photoreactive resin 20. The shape and size of the support member 40 are the same as those in the structure 1A.

Step 1500 is then performed to obtain a structure 2B attached to the support member 40 as shown in FIG. 7C. The structure 2B includes the support member 40 fixed to the upper face 20a of the photoreactive resin 20. Unlike the structure 2A, the structure 2B does not include the adhesive 46 between the support member 40 and the upper face 20a of the photoreactive resin 20.

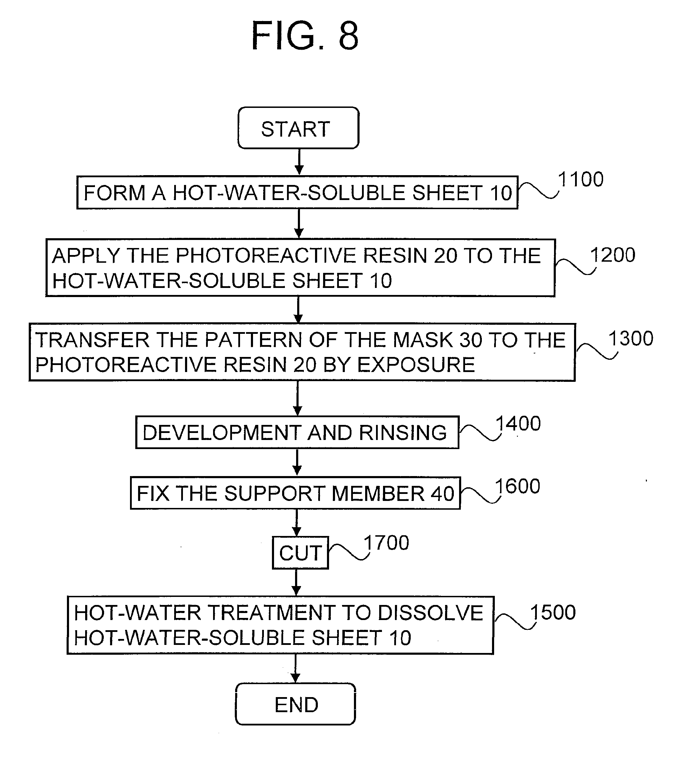

The structures 2A and 2B may be used as they are. Alternatively, a single or plurality of structures formed by cutting the structures 2A and 2B may be used. Such an embodiment will be described below with reference to FIGS. 8 to 9C. FIG. 8 shows the steps in a modification of the production method shown in FIG. 3. FIG. 8 differs in Step 1700 provided between Steps 1500 and 1600 from FIG. 3.

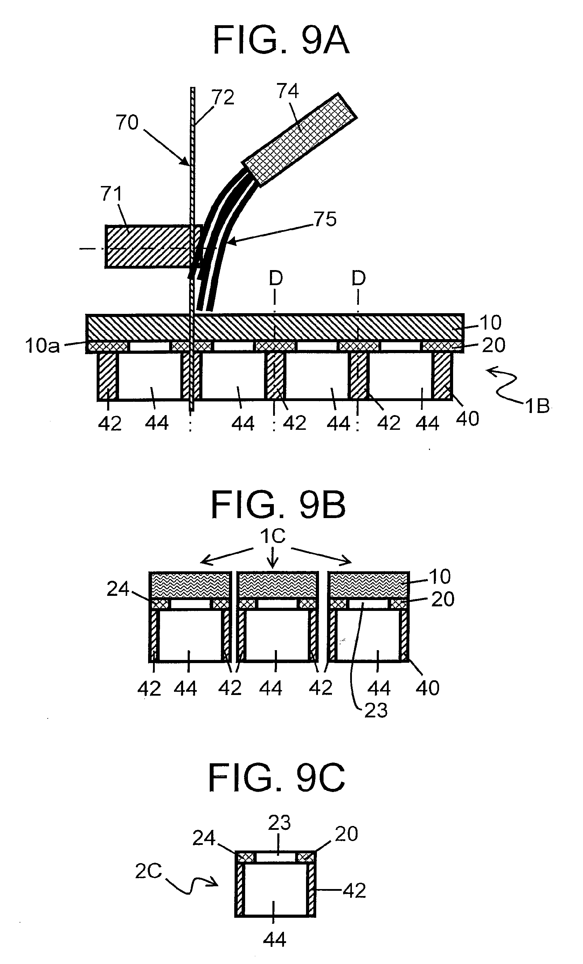

Referring to FIG. 8, the structure 1A or 1B is cut (Step 1700) subsequent to Step 1600. As shown in FIG. 9A, cutting is performed with a dicing blade 70. The dicing blade 70 includes a rotational component 71 and a blade 72 fixed to the rotational component 71. The dicing blade 70 cuts the structure 1B into pieces. The structure 1B shown in FIG. 9A may be replaced with the structure 1A. As shown in FIG. 9B, each of the resulting pieces is a structure 1C including the hot-water-soluble sheet 10, the photoreactive resin 20 having one of the through holes 23, and the support member 40.

The back surface 10b side of the hot-water-soluble sheet 10 faces to the dicing blade 70 side before the structure 1B is cut with the dicing blade 70. The blade 72 cuts the structure 1B along the center line D of each post 42 of the support member 40. A coolant 75 is supplied from a tank 74 to a cutting position of the blade 72. The hot-water-soluble sheet 10 prevents the entry of chips into the posts 42.

The structure 1C shown in FIG. 9B may be immediately subjected to Step 1500 to form a structure 2C shown in FIG. 9C. The structure 2C includes the support member 40 fixed to the photoreactive resin 20. In the case where the structure 2C is packed, transported, and unpacked, it is preferred that the structure 1C be subjected to these steps and then Step 1500 immediately before use as a device. Thus, the hot-water-soluble sheet 10 prevents the entry of foreign matter into the posts 42 during these steps. That is, according to this embodiment, the sheet can prevent the entry of chips into the photoreactive resin and the support member during cutting.

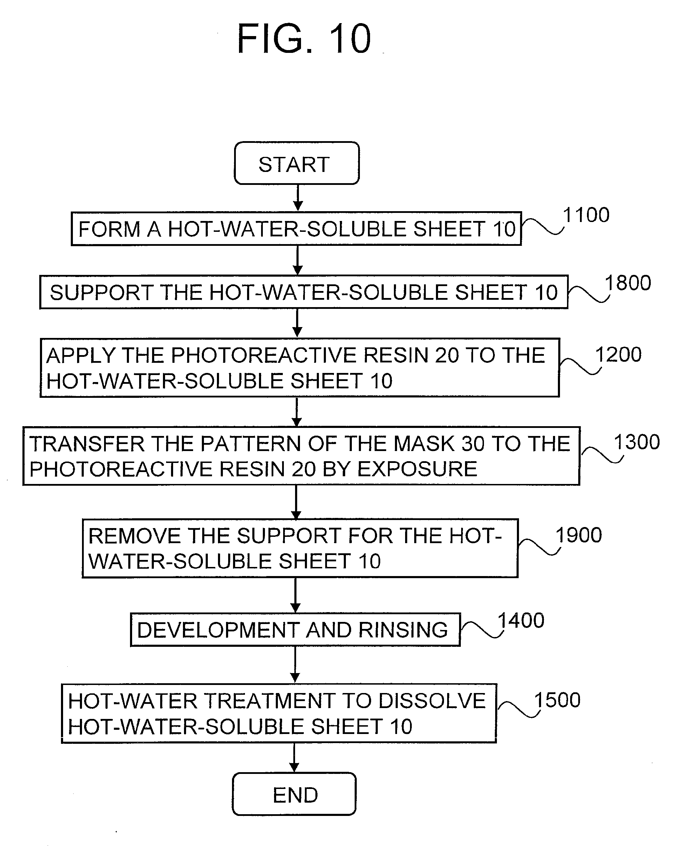

In the production method according to FIG. 1, from the viewpoint of handling, the hot-water-soluble sheet 10 is preferably supported with a support structure until exposure is completed. Such an embodiment will be described below with reference to FIG. 10. FIG. 10 shows the steps in a modification of the production method shown in FIG. 1. The modification method shown in FIG. 10 differs from the production method shown in FIG. 1 in that Step 1800 is provided between Steps 1100 and 1200 and in that Step 1900 is provided between Steps 1300 and 1400. Referring to FIG. 10, the hot-water-soluble sheet 10 is supported (Step 1800) subsequent to Step 1100.

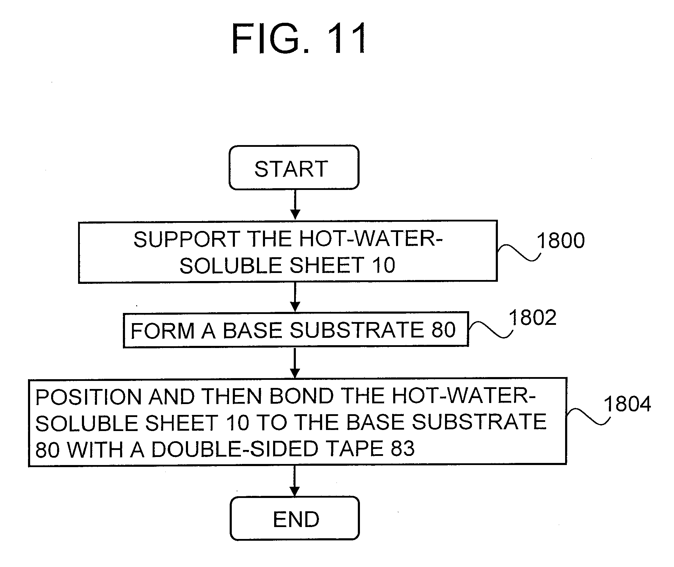

Step 1800 will be described in detail with reference to FIGs. 11 to 14G. FIG. 11 illustrates details of Step 1800.

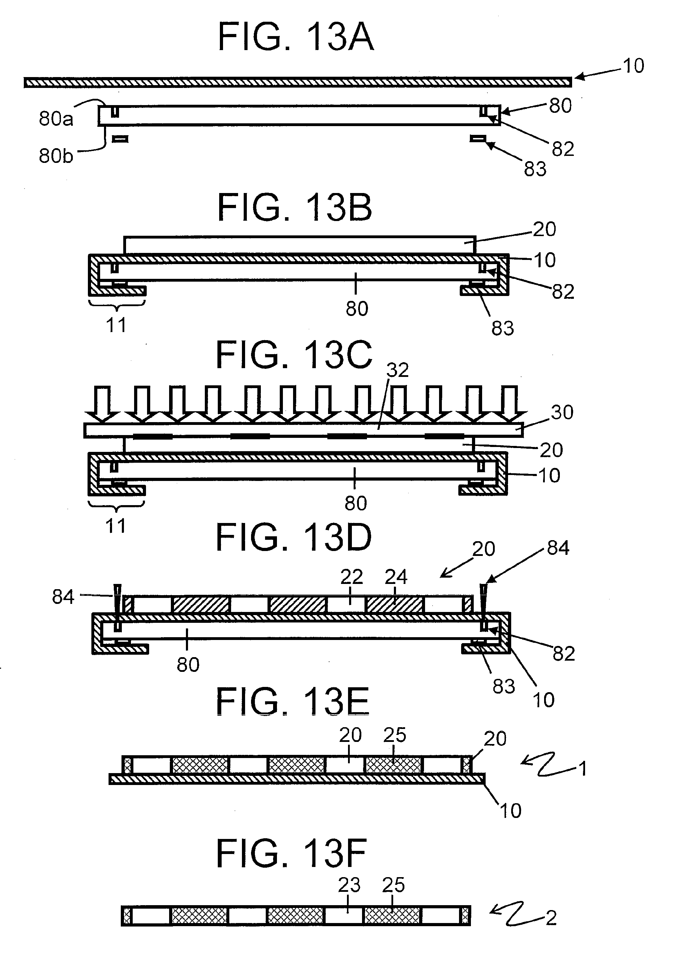

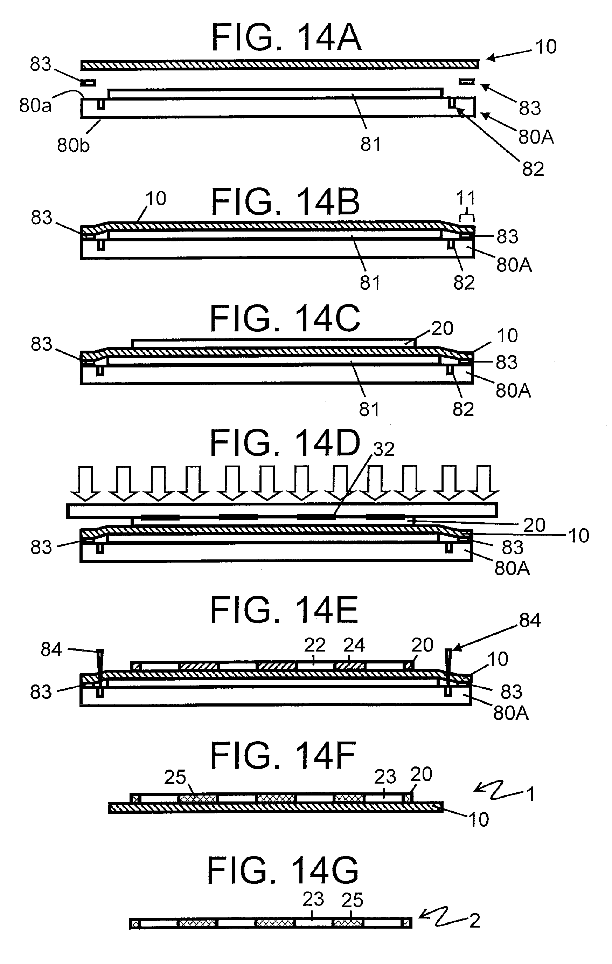

A base substrate 80 is formed (Substep 1802). As shown in FIG. 13A, the base substrate 80 according to an embodiment is a flat plate having a groove 82 on a surface 80a and is composed of a resin or glass. The base substrate 80 has a rectangular shape when viewed in plan. The groove 82 is in the form of a rectangle larger than the outside shape of the structure 2. The groove 82 is formed outside an exposure region. In this embodiment, the base substrate 80 is formed by injection molding with a thermoplastic resin. According to another embodiment, as shown in FIG. 14A, a base substrate 80A having a bump 81 is used in place of the base substrate 80. A plat plate including the bump 81 covers the exposure region. The height of the bump 81 is higher than that of a surrounding flat portion.

The hot-water-soluble sheet 10 is positioned and then bonded to the base substrate 80 with a double-sided tape 83 (Substep 1804).

In an embodiment, as shown in FIG. 13A, after positioning, the hot-water-soluble sheet 10 is bent at edges of the surface 80a of the base substrate 80. Ends 11 of the hot-water-soluble sheet 10 are bonded to the back surface 80b of the base substrate 80. Thereby, the flatness of the hot-water-soluble sheet 10 can be maintained on the surface 80a side of the base substrate 80. FIG. 13A is a schematic cross-sectional view showing a state in which the hot-water-soluble sheet 10 is positioned with respect to the base substrate 80.

According to another embodiment, as shown in FIG. 14A, after the hot-water-soluble sheet 10 is positioned, the ends 11 of the hot-water-soluble sheet 10 are bonded to ends of the base substrate 80A outside the groove 82 on the surface 80a with a double-sided tape 83. That is, a bonding portion is formed in a peripheral portion which has a small height and is located outside the exposure region. FIG. 14A is a schematic cross-sectional view showing a state in which the hot-water-soluble sheet 10 is positioned with respect to the base substrate 80A. FIG. 14B is a schematic cross-sectional view showing a state in which the hot-water-soluble sheet 10 is bonded to the base substrate 80A.

The photoreactive resin 20 is applied to the hot-water-soluble sheet 10 (Step 1200). FIGs. 13B and 14C are schematic cross-sectional views showing the state. The photoreactive resin 20 is applied to a region of the hot-water-soluble sheet 10 interior to the groove 82. In particular, in FIG. 14C, the height of the peripheral region is lower than the central exposure region. Thus, in the case where the photoreactive resin 20 is applied by spin coating, a stable thickness can be ensured.

The pattern 32 of the mask 30 is transferred to the photoreactive resin 20 by exposure (Step 1300). FIGs. 13C and 14D are schematic cross-sectional views showing a state during exposure.

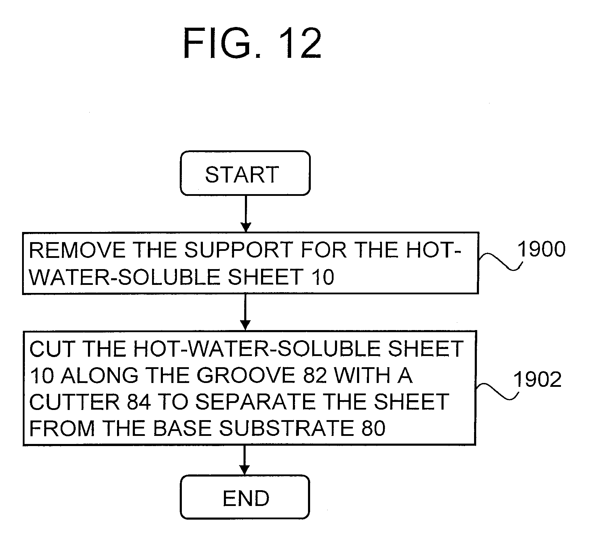

Support for the hot-water-soluble sheet 10 is removed (Step 1900). As shown in FIG. 12, in this embodiment, the hot-water-soluble sheet 10 is cut along the groove 82 with a cutter 84 to separate the sheet from the base substrate 80 (Substep 1902). FIGs. 13D and 14E are schematic cross-sectional view showing a state during cutting. A method shown in FIG. 13D is useful for exposure treatment utilizing a substrate having a polygonal outer shape.

Development and rinsing are performed (Step 1400) to form the substrate 1 similar to that shown in FIG. 2D, as shown in FIGs. 13E and 14F. Hot-water treatment is performed (Step 1500) to form the structure 2 similar to that shown in FIG. 2E, as shown in FIGs. 13F and 14G. According to the embodiment with reference to FIGs. 13A to 14G, the sheet member is easily supported with the base substrate. According to the embodiment with reference to FIGs. 14A to 14G, a stable thickness of the photoreactive resin is ensured.

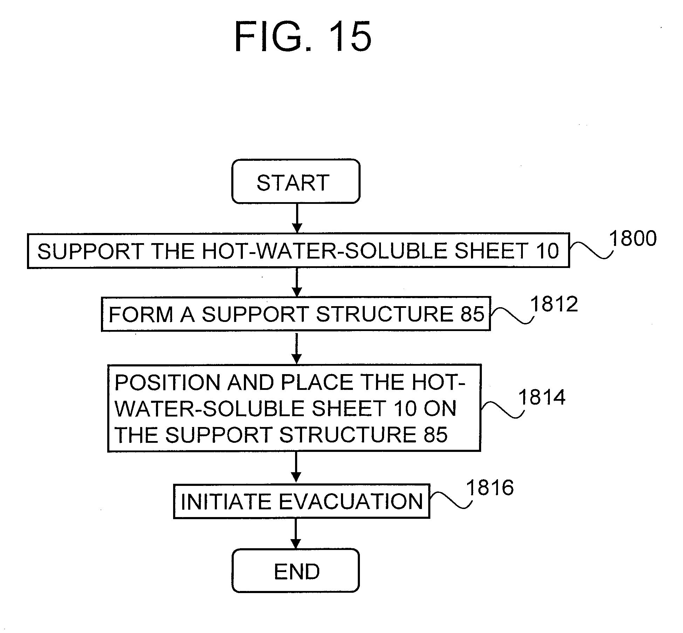

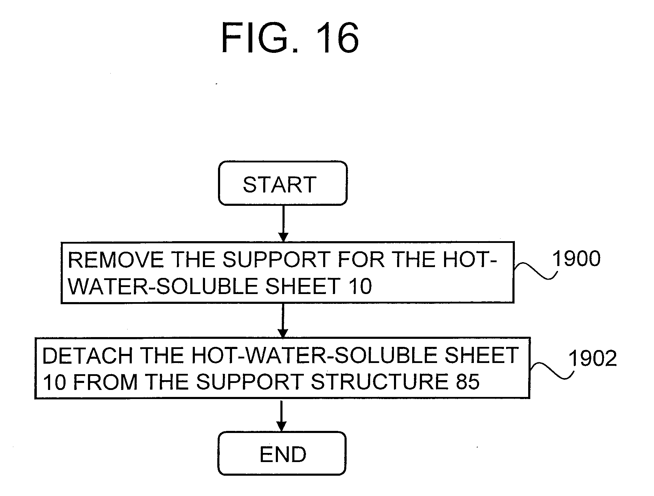

Examples of modifications of Step 1800 shown in FIG. 11 and Step 1900 shown in FIG. 12 will be described in detail with reference to FIGs. 15 to 17F. FIG. 15 illustrates an example of a modification of the details of Step 1800 shown in FIG. 11. FIG. 16 illustrates an example of a modification of the details of Step 1900 shown in FIG. 12.

A support structure 85 is formed (Substep 1812). The support structure 85 includes a porous member 87 mounted on a box 86. The box 86 is composed of aluminum or the like and is in the form of a cylinder or a substantially rectangular parallelepiped. The box 86 includes a bump 86a and an exhaust port 86c. The bump 86a protrudes from the inner surface toward the inside of the box 86. The bump 86a is provided along the internal circumference of the box 86 at a constant height from the bottom face 86d of the box 86. The bump 86a serves as a support for the porous member 87. When the porous member 87 is attached to the bump 86a, a exhaust space 86b is formed between the back surface 87b of the porous member 87 and the bottom face 86d. The exhaust space 86b communicates with the exhaust port 86c. The exhaust port 86c is connected to a vacuum pump (not shown) through a line 88 and a valve 89. The exhaust space 86b is thus evacuated from the exhaust port 86c. The exhaust space 86b is maintained at reduced pressure while the hot-water-soluble sheet 10 is supported. The porous member 87 is composed of a ceramic material or the like and is in the form of a cylinder or a substantially rectangular parallelepiped. A surface 87a of the porous member 87 is flush with the top face 86e of the box 86. Reducing the pressure in the exhaust space 86b causes suction from the surface 87a of the porous member 87.

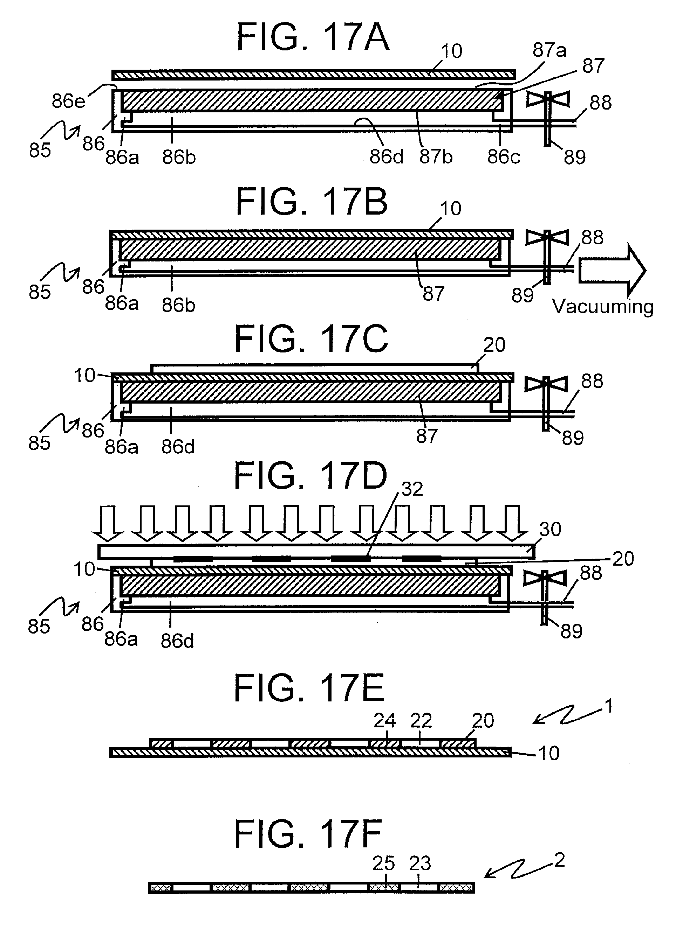

The hot-water-soluble sheet 10 is positioned and placed on the support structure 85 (Substep 1814). Dimensions of the hot-water-soluble sheet 10 at this point correspond to dimensions of the hot-water-soluble sheet 10 shown in FIGs. 13D and 14E after cutting. The valve 89 is closed during positioning and placing; hence, the pressure of the exhaust space 86b is atmospheric pressure. Thus, the hot-water-soluble sheet 10 is merely placed on the top face 86e of the box 86 and on the surface 87a of the porous member 87 of the support structure 85 and is not fixed. FIG. 17A is a schematic cross-sectional view showing the hot-water-soluble sheet 10 and the support structure 85 after positioning.

Evacuation is initiated (Substep 1816). The valve 89 is opened during evacuation; hence, the pressure in the exhaust space 86b is reduced. Thus, the hot-water-soluble sheet 10 is sucked and fixed to the surface 87a of the porous member 87 of the support structure 85. FIG. 17B is a schematic cross-sectional view showing a state of the hot-water-soluble sheet 10 fixed to the support structure 85 after evacuation.

The photoreactive resin 20 is applied to the hot-water-soluble sheet 10 while the evacuation is continued (Step 1200). FIG. 17C is a schematic cross-sectional view showing this state. The pattern 32 of the mask 30 is transferred to the photoreactive resin 20 by exposure while the evacuation is continued (Step 1300). FIG. 17D is a schematic cross-sectional view showing a state during exposure.

Support of the hot-water-soluble sheet 10 is removed (Step 1900). In this embodiment, evacuation is terminated, and then the hot-water-soluble sheet 10 is detached from the support structure 85 (Substep 1912) FIG. 17E is a schematic cross-sectional view showing a state after separation. Cutting operation with the cutter 84 shown in FIGs. 13D and 14E is not required, thereby improving workability.

Development and rinsing are performed (Step 1400). Thereby, the substrate 1 similar to that shown in FIG. 2D is obtained. Hot-water treatment is performed (Step 1500). Thereby, the structure 2 similar to that shown in FIG. 2E is obtained, as shown in FIG. 17F. According to this embodiment, the sheet member is easily supported by the porous member and evacuation. Furthermore, the sheet member is easily detached from the porous member by terminating evacuation.

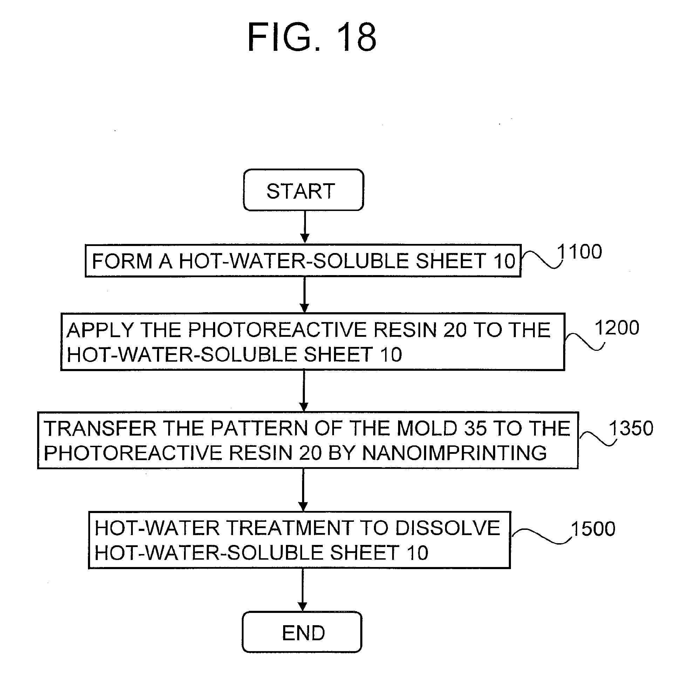

In Step 1300 shown in FIG. 1, pattern transfer is performed by exposure. In another embodiment, pattern transfer is performed by nanoimprinting. In this case, a mold 35 having a relief pattern 36 is used in place of the mask 30. This embodiment will be described below with reference to FIG. 18 to 19E. FIG. 18 shows the steps in a production method according to this embodiment.

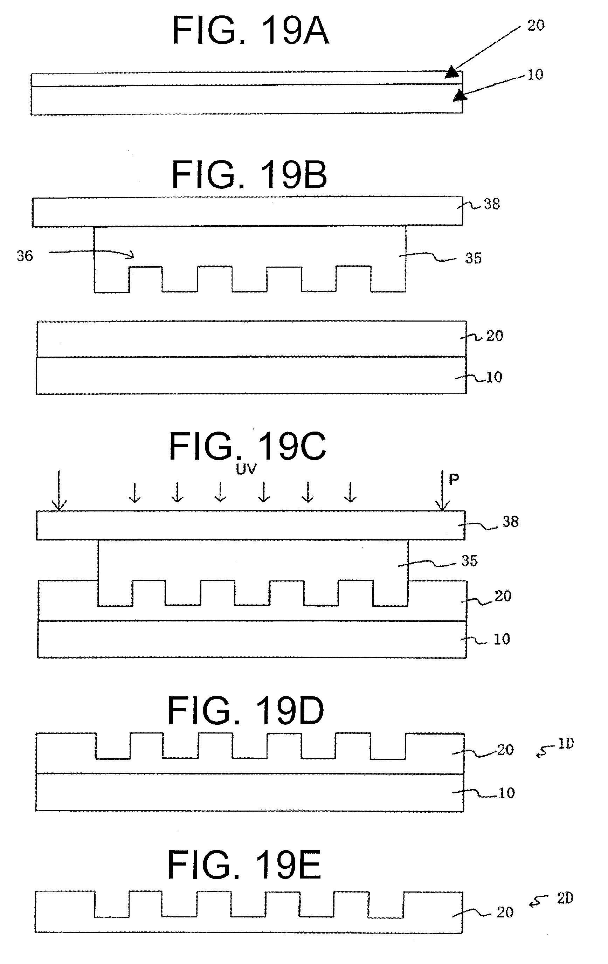

The hot-water-soluble sheet 10 is formed (Step 1100). As shown in FIG. 19A, the photoreactive resin 20 is applied to the hot-water-soluble sheet 10 as in the step shown in FIG. 2A (Step 1200). The pattern of the mold 35 is transferred to the photoreactive resin 20 by nanoimprinting (Step 1350). Specifically, as shown in FIG. 19B, the hot-water-soluble sheet 10 and the photoreactive resin 20 are mounted to a nanoimprinting apparatus (not shown) and positioned with respect to the mold 35 mounted on a pressure plate 38. As shown in FIG. 19C, the mold 35 is pressed against the photoreactive resin 20 with the pressure plate 38 and irradiated with ultraviolet rays. The pressure plate 38 and the mold 35 are each composed of a light-transmitting material such as quartz. The photoreactive resin 20 can be irradiated with ultraviolet rays through the pressure plate 38 and the mold 35 so as to effect curing. Then the mold 35 is detached from the photoreactive resin 20. FIG. 19D is a schematic cross-sectional view showing a structure 1D including the photoreactive resin 20 and the hot-water-soluble sheet 10. The hot-water-soluble sheet 10 is dissolved by hot-water treatment to obtain a structure 2D shown in FIG. 19E (Step1500).

According to the production method, the sheet member is dissolved in hot water to detach the structure from the sheet member. There is no possibility of damage to the structure because the sheet member is only soaked in hot water. Thus, the (micro)structure formed by transferring the pattern by nanoimprinting can be obtained simply and stably. Hot water is inexpensive and also environmentally friendly.

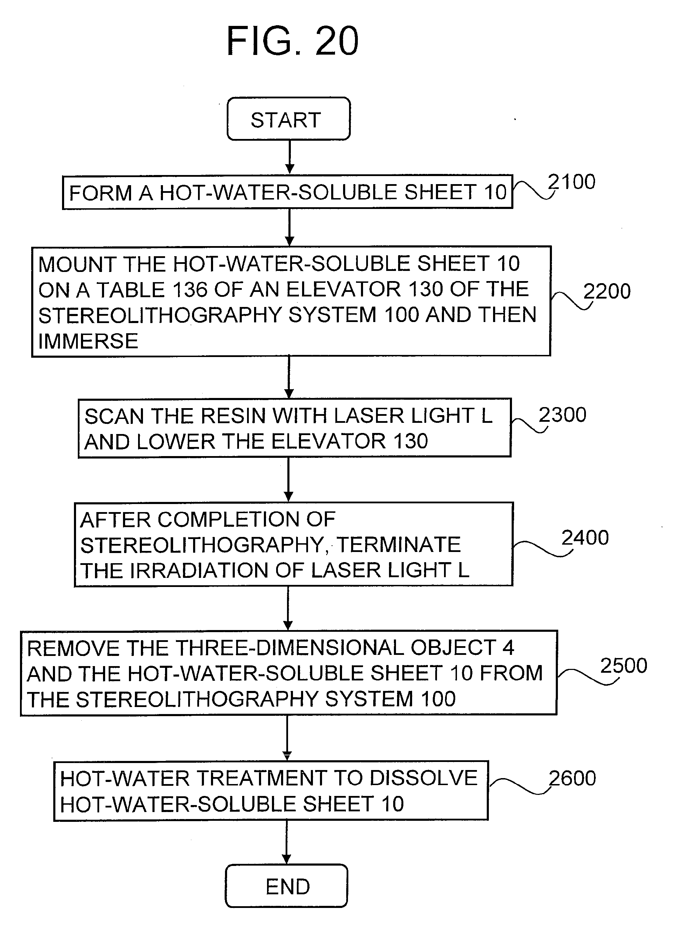

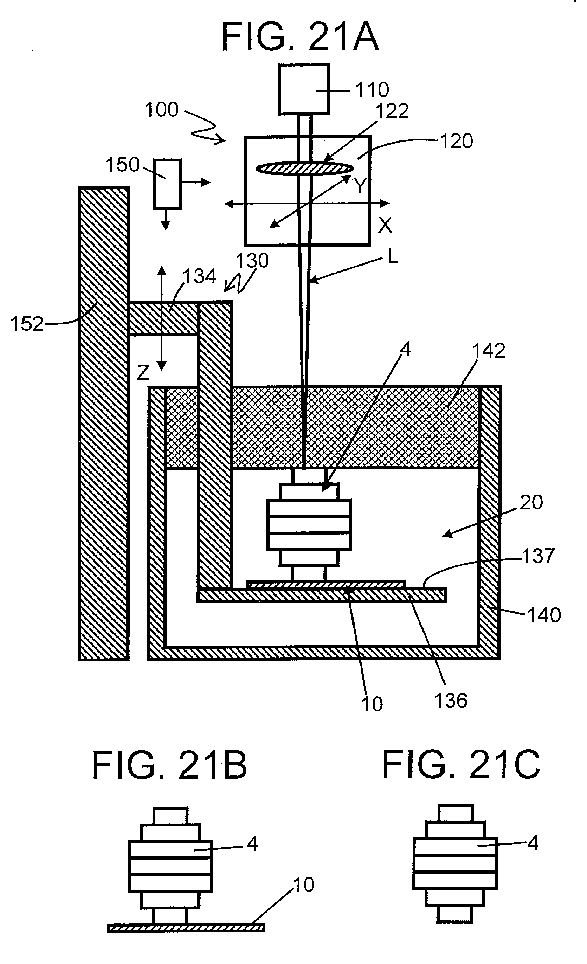

An embodiment in which the hot-water-soluble sheet 10 is applied to stereolithography will be described below with reference to FIGs. 20 to 21C. FIG. 20 shows the steps in a production method according to this embodiment. FIG. 21A is a schematic cross-sectional view of a stereolithography system. The hot-water-soluble sheet 10 is formed (Step 2100) as in Step 1100. The hot-water-soluble sheet 10 is mounted on a table 136 of an elevator 130 of the stereolithography system 100 and then immersed (Step 2200).

The stereolithography system 100 includes a light source 110, a scanner 120, the elevator 130, a tank 140, and a controlling unit 150. The light source 110 is constituted by ultraviolet laser such as KrF excimer laser. The scanner 120 includes an optical system 122 having a lens and a mirror. The scanner 120 guides laser light L emitted from the light source 110 and scans a photoreactive resin in the xy-plane. The elevator 130 includes a post 132, an L-shaped arm 134 that moves along the post 132 in the z-direction, and the table 136 attached to the arm 134. The hot-water-soluble sheet 10 is placed on the top face 137 of the table 136. The tank 140 has a box shape, contains the photoreactive resin (photocurable resin) 20, and includes a lid 142 composed of a light-transmitting material. As the photocurable resin of this embodiment for stereolithography, TSR820 may be used. The controlling unit 150 controls operations of the light source 110, the scanner 120, and the elevator 130 on the basis of information of an object to be shaped. The stereolithography system 100 may have a structure as is well known to those skilled in the art. Thus, description in detail is omitted.

The controlling unit 150 initiates stereolithography by scanning the resin with laser light L and lowering the elevator 130 (Step 2300). Specifically, a three-dimensional model is divided into slices and converted into contour-line data. The controlling unit 150 controls the scanner 120 on the basis of the contour-line data. Thereby, laser light L scans across the surface of the photoreactive resin 20 in the tank 140 through the lid 142 so as to draw the cross-sectional shape. A portion irradiated with laser light L is cured to form one cross-sectional layer of the shape on the table 136. The controlling unit 150 lowers the arm 134 attached to the elevator 130 by one layer at a time. A plurality of thin cross sections are continuously laminated, thereby forming a three-dimensional object corresponding to the three-dimensional model. By repeating this procedure, a three-dimensional object 4 is formed. After completion of stereolithography, the controlling unit 150 terminates the irradiation of laser light L form the light source 110 (Step 2400).

The controlling unit 150 lifts the arm 134 to remove the three-dimensional object 4 and the hot-water-soluble sheet 10 from the stereolithography system 100. FIG. 21B is a schematic cross-sectional view of the three-dimensional object and the hot-water-soluble sheet 10 removed from the stereolithography system after shaping.

The hot-water-soluble sheet 10 is dissolved by hot-water treatment. Thereby, the three-dimensional object 4 is obtained shown in FIG. 21C. According to the production method, the sheet member is easily detached from the table for supporting the sheet member. Furthermore, the three-dimensional object is easily detached from the sheet member by means of hot water. Thereby, the three-dimensional object can be produced simply and stably.

The embodiments of the present invention have been described above. The present invention is not limited to these embodiments. Various modifications and changes can be made without departing from the scope of the invention.

The present invention provides a method for simply producing a structure composed of a photoreactive resin without damaging the structure.

## Claims

1. A method for producing a structure comprising a photoreactive resin having photoreactivity, the method comprising the steps of:
forming the photoreactive resin on a sheet member soluble in water;
exposing the photoreactive resin selectively to a radiation activating the photoreactivity to produce the structure; and
dissolving the sheet member in water after the exposing step.

2. The method according to claim 1, wherein the step of forming photoreactive resin includes:
applying the photoreactive resin on the sheet member; and
developing the photoreactive resin after the exposing step, the developing step being done before the dissolving step.

3. The method according to claim 2, wherein the exposing step includes exposing the photoreactive resin in liquid state, applied on the sheet member thorough a pattern of mask having a light-shading portion and a light-transmitting portion, the pattern being transferred to the photoreactive resin.

4. The method according to any preceding claim, wherein the forming step includes:
applying the photoreactive resin on the sheet member;
transferring a pattern of a mold to the photoreactive resin in liquid state, applied on a sheet member, the pattern being transferred by nanoimprinting.

5. The method according to any preceding claim, wherein the sheet member is soluble at an elevated temperature, and the step of dissolving the sheet member is done at the elevated temperature.

6. The method according to any preceding claim 1, wherein the sheet member comprises agar.

7. The method according to any preceding claim, wherein the sheet member comprises a polyvinyl alcohol resin.

8. The method according to any preceding claim, further comprising the step of:
fixing a support member on the photoreactive resin for supporting the photoreactive resin.

9. The method according to claim 8, further comprising the steps of:
mounting a mold to the photoreactive resin, the mold having a channel in response to the support member; and
introducing the resin to the mold so as to fix the support member to the photoreactive resin.

10. The method according to claim 8 or 9, further comprising the step of:
cutting the sheet member, the photoreactive resin and the support member by a blade, the sheet member facing the blade.

11. The method according to claim 2, further comprising the step of:
bonding the sheet member to a base substrate having a groove with a double-sided tape before the exposing step; and
cutting the sheet member along the groove so as to remove the sheet member from the base substrate.

12. The method according to claim 4, further comprising the step of:
bonding the sheet member to a base substrate having a groove with a double-sided tape before the exposing step; and
cutting the sheet member along the groove so as to remove the sheet member from the base substrate.

13. The method according to claim 11 or 12, wherein the base substrate has a bump facing the sheet member, a height of the bump is higher than a thickness of the double-sided tape, and the applying step is done by spin-coating method.

14. The method according to any preceding claim, further comprising the step of:
placing the sheet member on a side of a porous member before the exposing step;
fixing the sheet member on the side of the porous member by sucking from the other side of the porous member; and
detaching the sheet member from the side of the porous member by stopping sucking before the developing step.

15. The method according to any preceding claim, wherein the forming step includes placing a sheet member in a photoreactive resin having liquidity, and the exposing step includes irradiating and scanning the photoreactive resin with a light from a light source, the sheet member being lowered step-by-step, the photoreactive resin being cured to form a structure on the sheet member.
